# EUROPEAN PATENT APPLICATION

(11) **EP 4 486 087 A1**
(43) Date of publication of application: **01.01.2025**
(21) Application number: 23210812.6
(22) Date of filing: 20.11.2023
(51) Int. Cl.: H10B 61/00, H10B 12/00, H10B 53/30, H10B 63/00, H01L 21/02

(54) **DOUBLE PATTERNING STRATEGY WITH PRINTED ERASABLE DUMMIFICATION**

(30) Priority: 29.06.2023 US 202318216485
(71) Applicant: Intel Corporation, Santa Clara, CA 95054 (US)
(72) Inventor: Gardiner, Allen, Portland, 97229 (US); Mehta, Nikhil, Portland, 97229 (US); Zhou, Shu, Portland, 97229 (US); LaJoie, Travis, Forest Grove, 97116 (US); Dgadhoh, Shem, West Linn, 97068 (US); Garg, Akash, Portland, 97229 (US); Le, Van, Beaverton, 97007 (US); Pello, Christopher, Beaverton, 97006 (US); Sell, Bernhard, Portland, 97229 (US)
(74) Representative: Goddar, Heinz J.

(57) **Abstract**

A method for manufacturing integrated circuit (IC) devices includes forming first and second mask patterns with overlapping and non-overlapping features. Non-overlapping features may be removed before etching a target material layer. A third mask pattern may be formed from the overlapping features and used to etch a target material layer. The third mask pattern may be employed to make regular arrays of substantially rectangular structures.

An IC device may include an IC die, an array of structures on a layer of the IC die, and multiple groups of parallel stripes of indentations or depressions in the layer. The structures may each include a transistor and a capacitor.

## Description

### BACKGROUND

In some applications, a wide range of patterning density is needed, e.g., to allow the deployment of integrated circuitry (IC) interconnect routing in the same chip and at the same level as backend memory devices in mixed ICs. Patterning devices with density variation impacts the etch and critical dimension (CD) control, which heavily impacts IC performance. With wide pattern density, etch control may not have enough signal to determine when etch should stop, which may require over-etch margin to control CDs and may still cause transistor and/or other CD variation in IC manufacturing. Patterned dummification in areas with low transistor density may enable satisfactory etch signaling for end-point and CD control. Conventional dummification occupies valuable chip area, which interferes with circuitry routing, degrades connection routing efficiency, and complicates routing design. Optical lithography patterning limitations may prevent achieving a consistent CD on all arrayed transistors, even if sub-resolution structures (e.g., on photomasks) and heavy optical proximity correction (OPC) are utilized. Such conventional techniques also do not solve etch-density problems because sub-resolution structures do not print on the wafer and so cannot provide etch-uniformity and end point detection improvement.

Improved patterning techniques are needed for improved etch and critical dimension control.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIG. 1 is a flow chart of methods for forming structures on a substrate using "AND" dual patterning, in accordance with some embodiments;
FIG. 2 is a flow chart of methods for forming structures on a substrate using "AND" dual patterning, in accordance with some embodiments;
FIGS. 3A, 3B, 3C, 3D, 3E, 3F, 3G, 3H, 31I, 3J, 3K, and 3L illustrate isometric views of an array of memory cells on an integrated circuit (IC) substrate, at various stages of manufacture, in accordance with some embodiments;
FIGS. 4A and 4B illustrate isometric and schematic views of an array of memory cells, in accordance with some embodiments;
FIGS. 5A, 5B, 5C, and 5D illustrate plan views of an IC die with an array of memory cells adjacent logic routing, in accordance with some embodiments;
FIGS. 6A, 6B, and 6C illustrate cross-sectional profile and isometric views of an array of embedded memory cells in an interconnect layer of an IC die, over arrays of transistor structures, in accordance with some embodiments;
FIG. 7 illustrates a diagram of an example data server machine employing an IC device having an array of structures formed with "AND" dual patterning, in accordance with some embodiments; and
FIG. 8 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Techniques and structures are disclosed to improve the performance of integrated circuit (IC) devices with strict etch requirements, e.g., with critical features requiring tight and consistent etch controls. "AND" dual patterning employs multiple, overlaid patterns to achieve high etch and critical dimension (CD) control, even across large pattern density variation. This "AND" dual patterning scheme creates "printed erasable dummification" where non-overlapped patterns are printed on a substrate. Printed erasable dummification can be printed to provide density during feature etch and then erased to clear area for other features (e.g., interconnect routing). Rather than occupying valuable die area and complicating or otherwise interfering with subsequent routing, dummification can be erased as desired features are patterned in a target material layer of a substrate. The final complete pattern (retained after dummification is erased) only occurs where both layers' patterns overlap each other. Orthogonal patterning enables sharp corners with minimal (e.g., virtually no) rounding and uniform CDs between features.

"AND" dual patterning refers to a patterning scheme where a final mask pattern is transferred into a target material layer of a substrate only where both of two precursor masks were patterned. Where only one of the precursor masks is patterned (the logical equivalent of an "OR" condition), an erasable dummy feature is printed. Although a feature is printed in one mask material, the feature will be removed prior to the mask pattern being transferred into a target material.

Erasable dummy features can be employed to provide improved etch controls. For example, macro loading may be optimized by filling otherwise-blank fields away from an array with interdigitated dummies. Again, each dummification feature can be patterned with a single precursor mask, so it can be removed to clear space for subsequent use (e.g., by interconnect routing). Such dummification can cover the vast majority of an IC wafer to provide improved etch control, e.g., superior end-pointing. Other dummies may be used at the edges of an array to maintain consistent micro loading. Erasable dummy features can be printed there to ensure chemistries (e.g., etchant concentrations) at array edges are matched to those internal to the array. The dummies can prevent excessive reactant gradients at array perimeters during etch processing, and the dummies can be removed when the arrays are complete and interconnects are to be routed.

Arrays of retained features or cells can be formed by overlapping mask patterns. The improved etch control of "AND" dual patterning scheme enables CD consistency across die, across wafer, across process, etc. Retained features can have consistent, sharp corners by intersecting (overlapping) orthogonal edges of multiple patterns instead of fabricating conventionally rounded corners from traditionally patterned features. Overlapping perpendicular arrays of parallel rows and columns can yield grid arrays of tightly controlled, right-angled cells that may be used for any of a variety of applications. Notably, such arrays are well-suited to large memory applications, such as random-access memory (RAM), and particularly embedded DRAM (dynamic RAM), as the erasable dummification enables fabrication of memory arrays in close proximity to (e.g., directly over) processing resources.

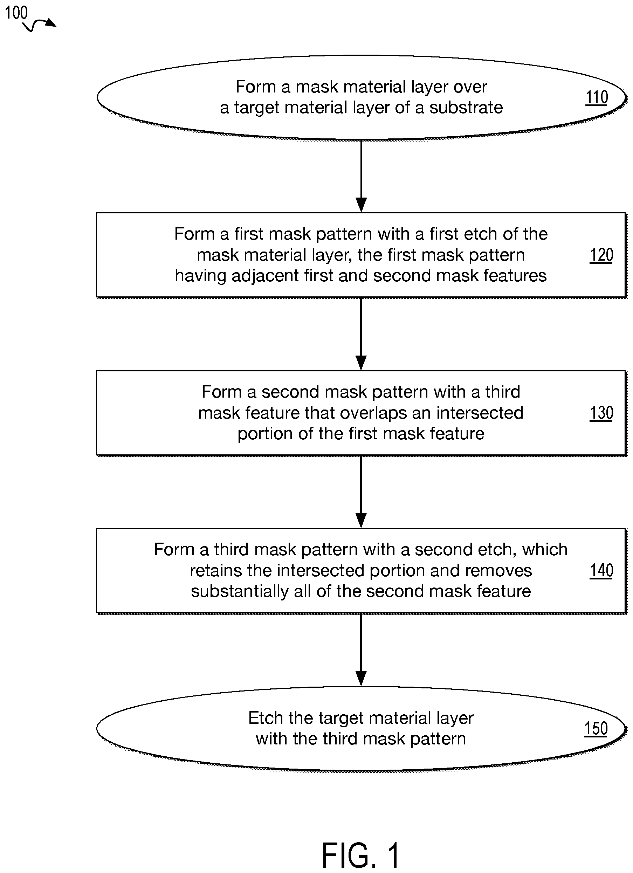

FIG. 1 is a flow chart of methods 100 for forming structures on a substrate, such as an array of memory cells, using "AND" dual patterning, in accordance with some embodiments. Methods 100 include operations 110-150. Some operations shown in FIG. 1 are optional. Additional operations may be included. FIG. 1 shows an example sequence, but the operations can be done in other orders as well, and some operations may be omitted. Some operations can also be performed multiple times before other operations are performed. For example, multiple mask layers may be formed. Some operations may be included within other operations so that the number of operations illustrated FIG. 1 is not a limitation of the methods 100.

Methods 100 begin with forming a mask material layer over a target material layer of a substrate at operation 110. The operation may employ any suitable materials and structures. For example, the substrate may be a semiconductor or insulator wafer or die, which may include multiple layers, including a target material layer. One or more target material layers may be deposited on or over the substrate, and one or more mask material layers may be deposited on or over the target material layer(s). Various material layers may be employed and may depend on the structure(s) to be formed on the substrate. In some embodiments, an array of memory cells is to be formed. In some such embodiments, a target material layer is of a dielectric material, which may be used to form an array of capacitors. In some specific embodiments, a target material layer includes a ferroelectric material. Other materials capable of storing charge (or otherwise storing digital information, e.g., in bits corresponding to discrete physical states, such as phase-change materials) may be utilized. In some embodiments, multiple target material layers may be formed over the substrate. For example, magnetoresistive memory structures may include multiple target material layers (e.g., multiple ferromagnetic, or ferromagnetic and antiferromagnetic, layers) over the substrate.

In some embodiments, a target material layer includes a semiconductor material, which may be used to form a transistor or an array of transistors. In some such embodiments, an array of memory cells is to be formed to include an array of transistors, e.g., with at least one transistor and one capacitor in each memory cell. In some embodiments, some processing, such as doping, is performed on one or more target material layers prior to the formation of any subsequent layers.

One or more mask material layers may also be deposited on or over the target material layer(s). A mask material may be employed to cover and shield portions of the target material layer(s) (e.g., portions to be retained) while leaving other portions exposed and available for removal, for example, by etching. Methods 100 may employ multiple mask layers, e.g., overlapping mask layers to overlap and combine multiple mask patterns, although later mask material layers may be deposited at later operations. For example, one or more subsequent mask material layers may be deposited after a mask is patterned in a first mask material layer. Multiple mask material layers may be chosen for any of various suitable reasons, e.g., their differing etch resistances to either oxygen- or halogen-rich plasma or other causes of an etch selectivity between the layers.

Methods 100 continue at operation 120 by forming, with a first etch of the mask material layer, a first mask pattern having a first mask material feature adjacent to a second mask material feature. For example, a first mask pattern may be etched into a first mask material layer using a lithographic layer (or stack) over the first mask material layer. The first mask pattern may be optically transferred onto a layer of photoresist over the first mask material layer, and the photoresist layer may act as a mask when an etchant (wet or dry) transfers the first mask pattern into the first mask material layer.

The first mask pattern may have multiple, adjacent mask material features, some of which may be overlapped by a subsequent mask pattern. For example, the first mask pattern may have first and second mask material features, and the first mask material feature(s) may overlap with one or more mask material features of a second (or other subsequent) mask pattern while the second mask material feature(s) may be non-overlapping with the mask material features of the subsequent mask pattern.

Methods 100 continue by forming a second mask pattern having a third mask material feature that overlaps an intersected portion of the first mask material feature at operation 130. The second mask pattern may be formed from a second mask material layer formed over the first mask pattern of the first mask material layer. For example, a lithographic stack may be deposited over the first mask pattern and then patterned as previously described (e.g., optically into a photoresist layer) with the second mask pattern. The second mask pattern could then be etched into the second mask material layer, or the lithographic stack (or a portion of the lithographic stack) could be utilized as the second mask material layer.

The second mask pattern may have multiple, adjacent mask material features, some of which may overlap the first mask pattern. For example, the second mask pattern may have third and fourth mask material features, and the third mask material feature(s) may overlap with one or more first mask material feature(s) of the first mask pattern while the fourth mask material feature(s) may be non-overlapping with the mask material features of the first mask pattern.

Methods 100 continue at operation 140 by forming (with a second etch of the first mask material layer) a third mask pattern, such that the second etch retains the intersected portion of the first mask material feature and removes the second mask material feature. For example, a third mask pattern may include the overlapping or intersecting portions of the first and second mask patterns, e.g., the overlapping or intersecting portions of the first and third mask material features. An etch may be performed using the second mask pattern to expose and remove the non-intersecting (e.g., non-overlapped) portions of the first mask material layer (e.g., all of the second mask material feature, as well as the non-intersected or -overlapped portions of the first mask material feature). One or more overlapped portions of the first mask pattern in the first mask material layer (e.g., the intersected portion of the first mask material feature with the third mask material feature) will still be masked by the second mask pattern (e.g., by the second mask material layer, such as a portion of a lithographic stack) and will be retained. An etch can also remove the entirety of the second mask material layer, which will remove the third and fourth mask material features and expose the remainder of the first mask material layer, e.g., the intersected portion(s) of the first mask material feature(s) in the first mask material layer.

The etch of the second mask material layer may employ a relatively high-energy plasma, which may or may not be selective to the second mask material. This etch of the second mask material layer may leave residual substrate marks, e.g., in the area of the fourth mask material feature(s), which may be referred to as a "latent image" in the exposed material layer. This latent image may show the outlines of one or more of the mask material features, e.g., the fourth mask material feature(s). For example, the fourth mask material features may be a group of parallel segments, and the latent image may be one or more corresponding groups of parallel stripes in the exposed material layer and adjacent the array, where each of the stripes are of indentations or depressions in the layer. The indentations or depressions in the layer may be formed by an over-etch of the layer and may be a roughening or erosion of the layer by the etchant, e.g., due to bombardment by a high-energy plasma. The latent image may be transferred (and modified) by any subsequent etch into lower material layers, e.g., of the substrate.

Methods 100 continue by etching at least partially through the target material layer based on the third mask pattern at operation 150. With the non-intersecting or -overlapping portions of the first mask material layer (and all of the second mask material layer) removed, the third mask pattern is in the remaining portion of the first mask material layer, e.g., the portion of the first mask material feature that was overlapped by the third mask material feature. An etch is performed at least partially through the target material layer employing the remaining mask material to transfer this third mask pattern into the target material layer. One or more additional mask materials (e.g., between the first mask material layer and a target material layer) may be employed.

Methods 100 may be used to form arrays in the target material(s) from the combined, third mask pattern, e.g., of overlapping intersections of the multiple mask patterns. One result of multiple mask patterns forming a combined, intersected (e.g., "AND"-ed) mask pattern is that features from a single mask pattern (e.g., "OR" features) may be printed (e.g., developed on the substrate) and used (e.g., for macro loading etch control, such as end-pointing) and then "erased" when the OR" features are no longer needed. Erasable features may also be printed at the edges of arrays for micro loading (e.g., maintaining etchant and etched chemistries at the edges of an array substantially consistent with those internal to the array) and then erased after a mask pattern is etched into a material layer. Another result is that the constituent mask patterns may have overlapping perpendicular segments that form rectangular intersected ("AND"-ed) mask features with nearly perfect, right-angled corners.

In some embodiments, the etch at operation 150 is entirely through the target material layer and etches the third mask pattern at least some depth into an underlying substrate material layer. In some such embodiments, the etch forms or transfers a latent image into the substrate material layer. The substrate material layer may be a target material layer or a material layer below the one or more target material layers. The etch at operation 150 may be through a target material layer or more than one target material layers. In some embodiments, multiple etches (e.g., with etchants altered between etches) are performed with the third mask pattern.

Further processing may be done following the "AND" dual patterning of methods 100. For example, an array of structures may be further processed. In some such embodiments, memory cells are further etched, and metallization or other interconnects are formed to the cells, e.g., to plates of capacitors (or other structures) and/or to transistor terminals. Build-up layers, such as of dielectric and metallization in interconnect layers in an IC die, may be formed over the printed features (e.g., an array of memory cells).

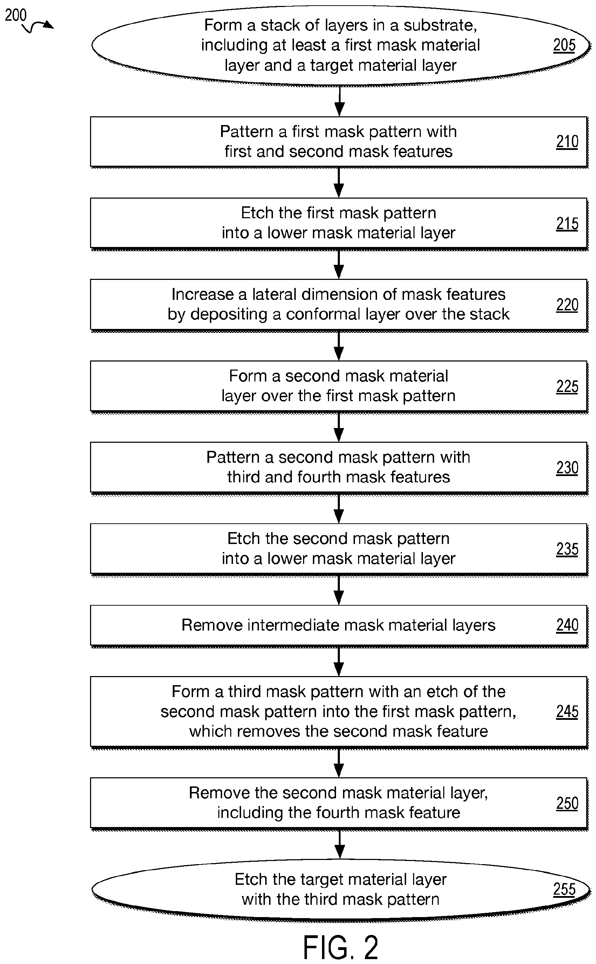

FIG. 2 is a flow chart of methods 200 for forming structures on a substrate, such as an array of memory cells, using "AND" dual patterning, in accordance with some embodiments. Methods 200 include operations 205-255, which may provide detailed example operations compatible with methods 100. Some operations shown in FIG. 2 are optional. Additional operations may be included. FIG. 2 shows an example sequence, but the operations can be done in other orders as well, and some operations may be omitted. Some operations can also be performed multiple times before other operations are performed. For example, multiple mask layers may be formed. Some operations may be included within other operations so that the number of operations illustrated FIG. 2 is not a limitation of the methods 200.

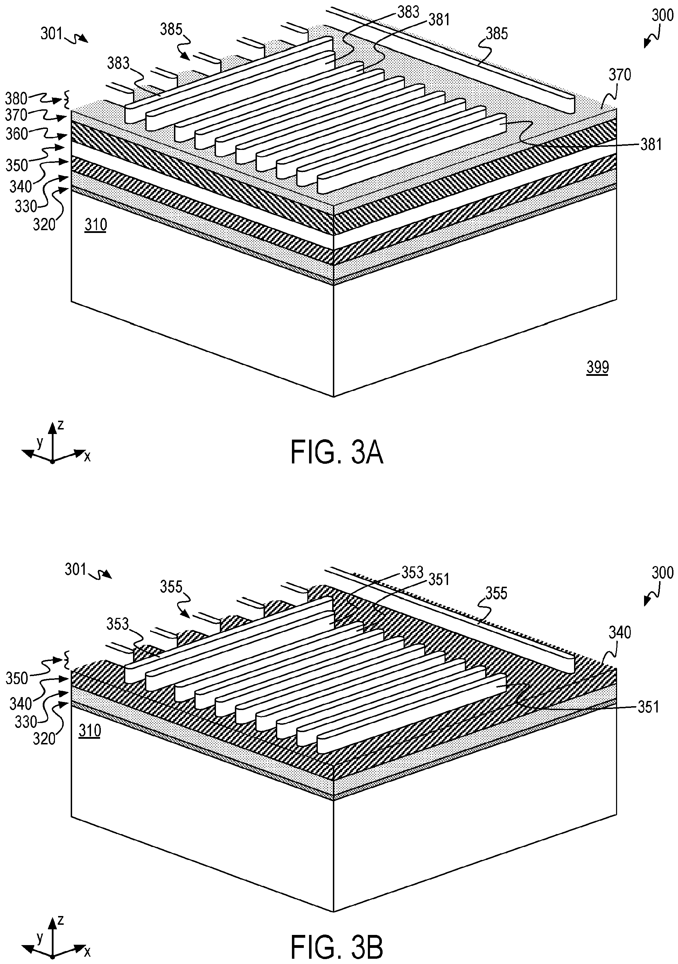

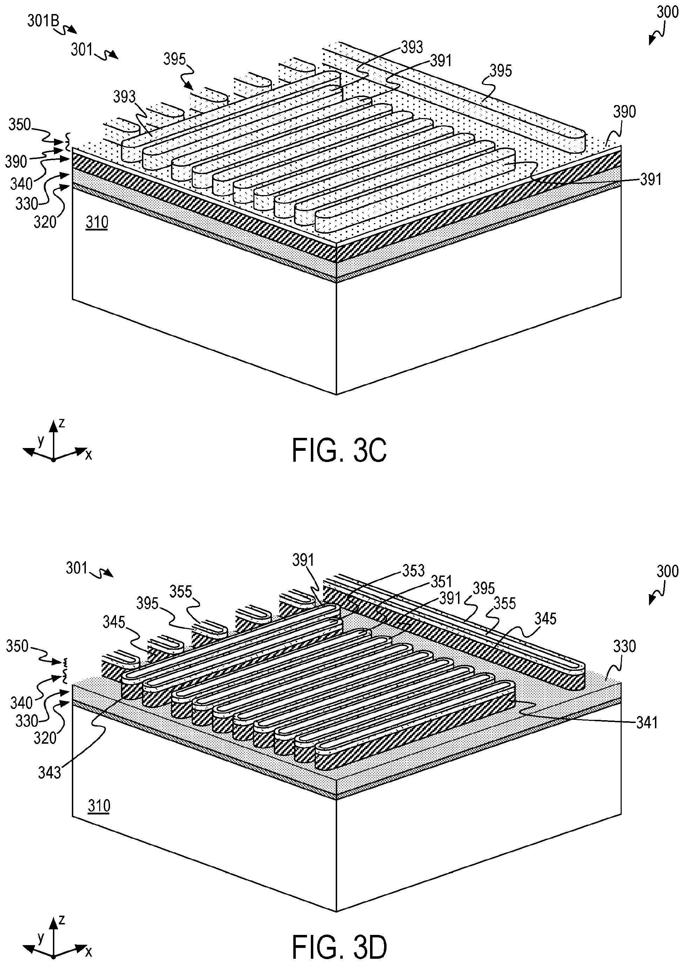

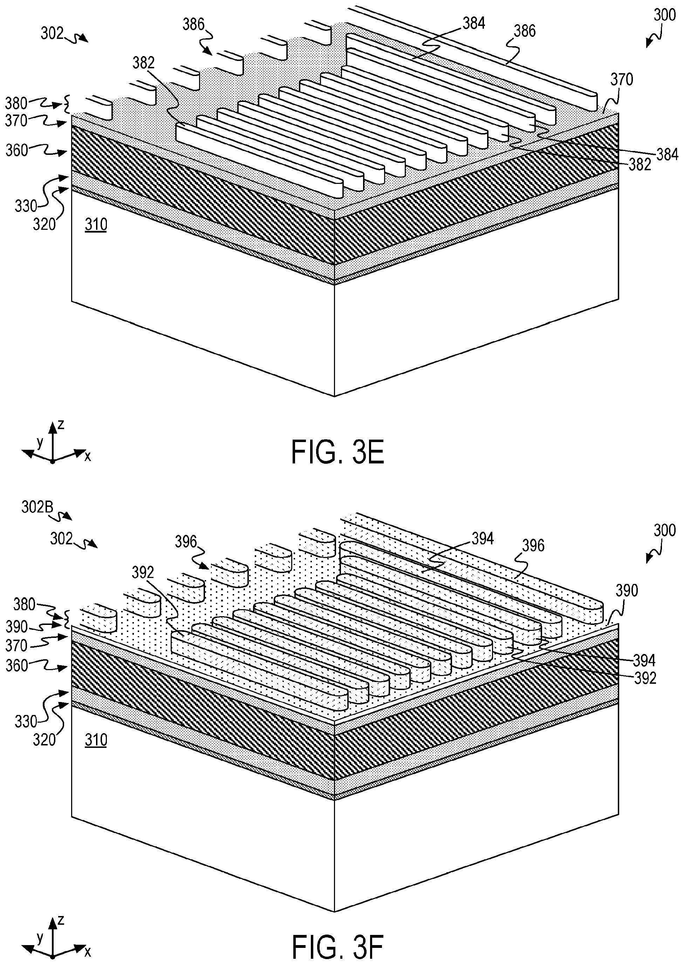

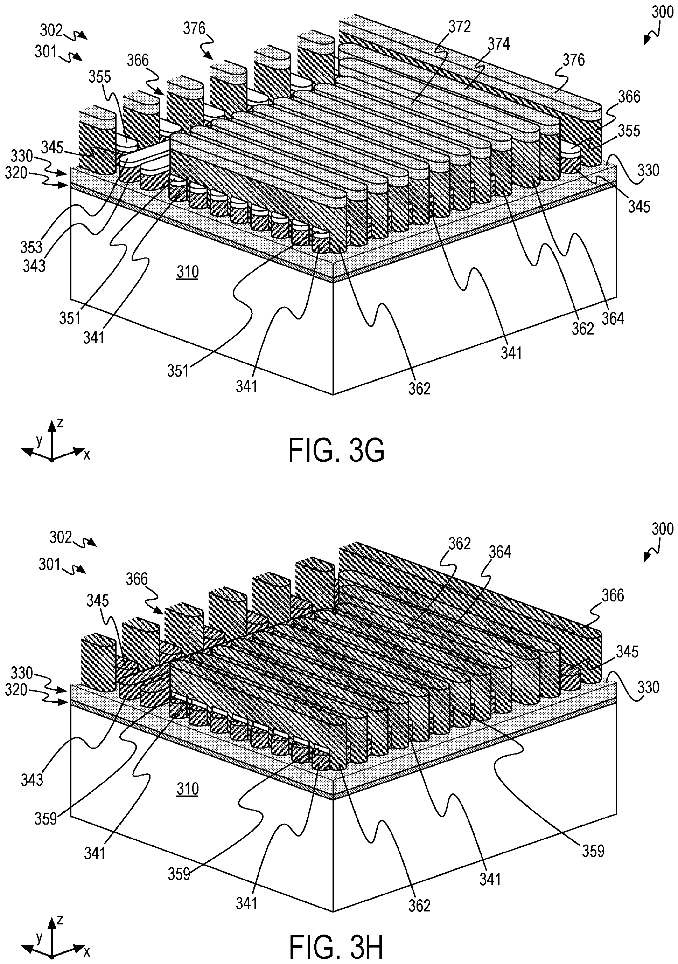

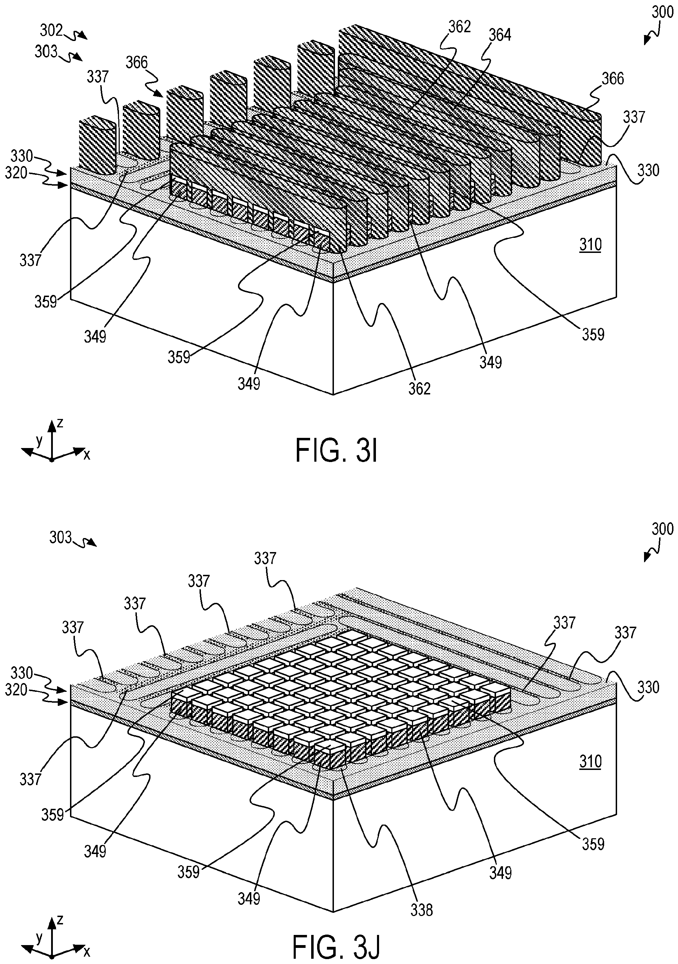

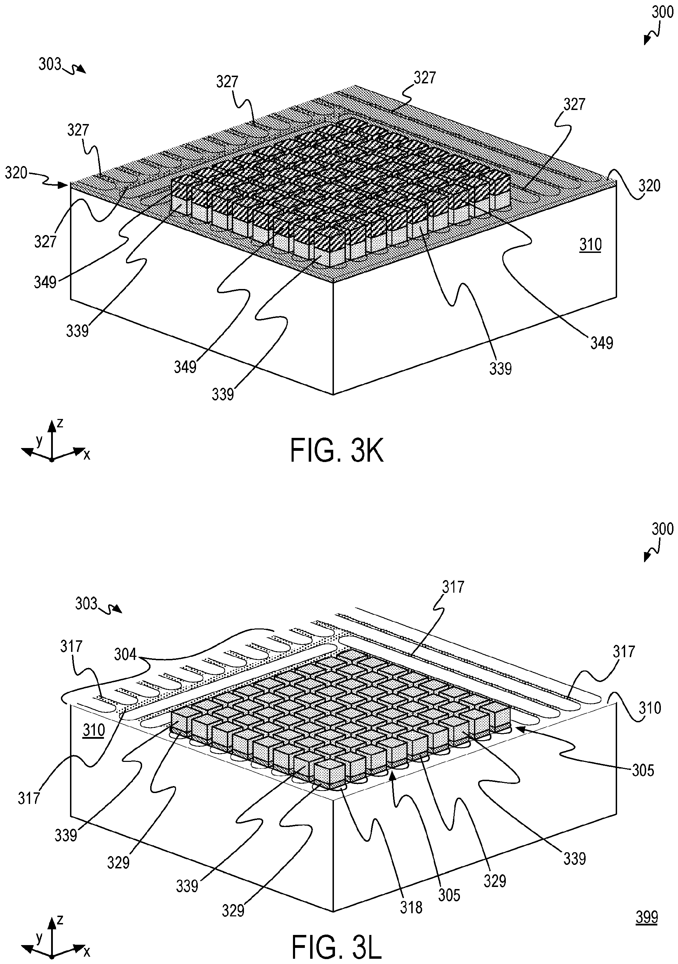

FIGS. 3A, 3B, 3C, 3D, 3E, 3F, 3G, 3H, 3I, 3J, 3K, and 3L illustrate isometric views of an array 304 of memory cells 305 on an IC substrate 310, at various stages of manufacture, in accordance with some embodiments.

Returning to FIG. 2, methods 200 begin with forming a stack of layers in a substrate, including at least a first mask material layer and a target material layer at operation 205. The operation may employ any suitable materials and structures. The substrate may be a wafer or die of an insulator or semiconductor material, such as silicon or other crystalline material. In many embodiments, the substrate includes monocrystalline silicon (Si), germanium (Ge), silicon germanium (SiGe), a III-V alloy material (e.g., gallium arsenide (GaAs)), a silicon carbide (e.g., SiC), a sapphire (e.g., Al₂O₃), or a combination thereof. The substrate may also include other semiconductor materials, metals, dielectrics, dopants, and other materials commonly found in semiconductor substrates. For example, the substrate may already include transistors (or partially-fabricated transistors, i.e., at an intermediate state of manufacture), e.g., in a layer below the upper surface of the substrate. The substrate may include one or more layers of metallization, such as for interconnecting transistors or other structures within and to the substrate. Methods 100 may be performed at any level of the substrate, but methods 100 may be especially useful for fabricating arrays of structures over other structures, e.g., within interconnect layers over transistors.

One or more target material layers may be formed over the substrate. The target material(s) may be chosen to suit the structure(s) to be formed. In some embodiments, a target material is a semiconductor material, for example, for forming a transistor or an array of transistors. In some such embodiments, a dielectric target material layer is over a semiconductor target material layer, for example, as a gate dielectric. A metal target material layer (e.g., for a gate metal) may similarly be over a dielectric target material layer. A semiconductor target material layer may have any suitable morphology or microstructure and any suitable composition. For example, a semiconductor target material may be a monocrystalline and elemental semiconductor, such as silicon. In many embodiments, a semiconductor material layer is substantially amorphous (e.g., having no discernable long-range order), slightly crystalline, or a more-ordered polycrystalline (e.g., microcrystalline or nanocrystalline) material. For example, a semiconductor material layer may be a thin-film semiconductor, such as polycrystalline silicon, polycrystalline germanium, or other materials including one or both of silicon and germanium (e.g., polycrystalline SiGe). In some embodiments, a semiconductor material layer includes a polycrystalline III-V material. A semiconductor material layer may utilize an organic thin-film semiconductor, which may include rubrene, pentacene, tetrathiafulvalene, etc.

A semiconductor material layer may include amorphous or polycrystalline materials that include a metal and oxygen, such as a metal oxide. A thin, metal-oxide film may be semiconducting substantially as-deposited, and/or following some subsequent activation process, such as a thermal anneal. Oxide semiconductor materials primarily include one or more metals (M1, M1M2, M1M2M3, etc.) and oxygen (O). The metal(s) may be from the transition metals (e.g., IUPAC group 4-10) or post-transition metals (e.g., IUPAC groups 11-15). The metal oxide compounds may be suboxides (A₂O), monoxides (AO), binary oxides (AO₂), ternary oxides (e.g., ABO₃), and mixtures thereof, for example. In some embodiments, a semiconductor material layer includes oxygen and at least one of magnesium (Mg), copper (Cu), zinc (Zn), tin (Sn), titanium (Ti), indium (In), gallium (Ga), or aluminum (Al).

A semiconductor alloy may include any atomic concentration ratio of constituents. For example, a binary metal alloy M1_{y}M2_{1-y} may include any atomic percent of a first metal (M1) and a complementary atomic percent of a second metal (M2), or metalloid/non-metal. A ternary alloy M1_{y}M2_{z}M3_{1-y-z} may include any atomic percent of metal M1, any atomic percent of metal M2, and a complementary atomic percent of a third metal (M3), such that y and z are both greater than 0, but sum to less than 1. Some compositions may be described as an alloy or a ceramic, e.g., depending on oxygen content. In some specific embodiments, a semiconductor material layer includes a zinc oxide (ZnOₓ), such as Zn(II) oxide, or ZnO, zinc peroxide (ZnO₂) or a mixture of ZnO and ZnO₂. In some specific embodiments, a semiconductor target material layer includes ZnOₓ and indium oxide InOₓ (e.g., In₂O₃). In some further embodiments, a semiconductor material includes a composition of In, Ga, Zn, and O (IGZO), e.g., zinc oxide, indium oxide, and gallium oxide (e.g., Ga₂O₃). The metal atomic composition ratio, for example Ga to each of In and Zn (Ga:In:Zn), may vary. In some embodiments, a semiconductor material layer includes a Ga-rich IGZO. In some specific embodiments, a semiconductor composition includes indium, oxygen, and another metal (such as Zn, Sn, tungsten (W), Ti, hafnium (Hf), zirconium (Zr), etc.). In some such embodiments, the semiconductor composition includes a thin film of indium oxide doped with the other metal, such as zinc (e.g., in indium zinc oxide (IZO)) or tin (e.g., in indium tin oxide (ITO)). Such semiconductors may be combined with other oxide or nitride insulators, such as a silicon oxide (e.g., SiO₂, etc.) or a silicon nitride (e.g., Si₃N₄, etc.).

A semiconductor material layer may include nitrogen, for example, combined with a group III material (such as gallium or indium) or other material (such as zinc). Such compositions may include or be combined with other semiconducting or insulating oxides and nitrides.

In some embodiments, a semiconductor target material layer includes ultrathin materials, e.g., two-dimensional (2D) materials, such as black phosphorous or a transition-metal dichalcogenide (TMD) material. TMDs are compounds that include chalcogenides (e.g., any of sulfur (S), selenium (Se), or tellurium (Te)) and transition metals, which are defined to include any element in the d-block of the periodic table, i.e., group 3 through group 12, and any element in the f-block of the periodic table, i.e., "inner transition metals." Dichalcogenides include twice as many chalcogenides as transition metal atoms. TMDs can be 2D materials, e.g., forming monolayers of semiconductor materials. In some embodiments, a semiconductor target material layer includes molybdenum (Mo) or tungsten. In some such embodiments, the semiconductor material is MoS₂, MoSe₂, WS₂, WSe₂, or CuS₂. A semiconductor target material may utilize other compositions.

A semiconductor target material may include one or more dopants such as another metal or a nonmetallic dopant, such as nitrogen, oxygen, hydrogen, fluorine, chlorine, silicon, or germanium, that may introduce electron vacancies or oxygen vacancies.

In some embodiments, a target material layer includes a dielectric material, for example, for forming a capacitor, an array of capacitors, or other structures capable of storing charge (or other means of storing information). The one or more layers of dielectric material may include silicon oxide, silicon dioxide (SiO₂), silicon nitride, and/or a high-permittivity ("high-K") dielectric material. The high-K dielectric material may include elements such as Hf, Si, O, Ti, tantalum (Ta), lanthanum (La), Al, Zr, barium (Ba), strontium (Sr), yttrium (Y), lead (Pb), scandium (Sc), niobium (Nb), and Zn, for example, in an oxide. Such dielectric materials may be binary compounds (such as an oxide of hafnium, zirconium, titanium, etc.), ternary compounds (such as strontium titanate, etc.), or have other compositions.

Many memory (e.g., random-access memory (RAM)) devices store data in a storage material layer between two conductive plates. For example, ferroelectric RAM (FeRAM) devices may store data in ferroelectric capacitors. Charge-trap memory may use, e.g., oxide and nitride layers between two conductive plates. Resistive RAM (ReRAM), magnetoresistive RAM (MRAM), phase-change memory (PCM) (or phase-change RAM (PRAM)), and other types of memory devices may be formed with a target material layer including a storage material.

A storage layer may employ one or more of multiple memory technologies and may also include one or multiple layers, e.g., sublayers, with different compositions or functions. For example, a memory cell structure may be part of, e.g., a FeRAM system, an MRAM system, or another crosspoint memory system. In some embodiments, a storage layer consists of a single layer of material, e.g., a single layer of a ferroelectric material in a FeRAM system. In other embodiments, a storage layer includes multiple layers of materials with differing compositions, such as an oxide-nitride-oxide stack in a charge-trap memory system. In some such embodiments, a storage layer includes silicon nitride (Si₃N₄ or Si₉N₁₀).

In some embodiments, an array of ReRAM cells utilizes resistance switching to store information and may include an oxygen exchange layer over a switching layer. In some embodiments, a second (or more) switching layer may be used. In some embodiments, a switching layer may be a metal oxide, e.g., including oxygen and atoms of one or more metals, such as but not limited to Al, Hf, Ta, Ti, W, or Zr. In some embodiments, a storage layer includes Sr and Zr (e.g., Sr₁₋ₓZrₓTiO₃ or Sr(Zr)TiOs). ReRAM memory cells need not employ oxygen exchange and switching layers. One or more other layers may be used.

As another example, in some embodiments, as part of an MRAM system, a bit of information is stored as a higher or lower resistant state of a storage layer based on the relative magnetic alignments of multiple layers of the storage layer. In some such embodiments, a storage layer includes two ferromagnetic layers, an intervening non-magnetic layer between them, and an antiferromagnetic layer. In some such embodiments, the intervening non-magnetic layer is a metal or metal oxide. In other such embodiments, the intervening non-magnetic layer is a dielectric. In some embodiments, a storage layer includes a ferromagnetic layer formed of CFGG (i.e., cobalt (Co), iron (Fe), germanium (Ge), or gallium (Ga) or a combination of them). In some embodiments, a storage layer includes one or more of Co, Fe, nickel (Ni) alloys and multilayer hetero-structures, various oxide ferromagnets, garnets, or Heusler alloys. In some embodiments, a storage layer includes a ferromagnetic layer with perpendicular magnetic anisotropy (PMA) and materials from a group including materials with L1₀ symmetry and/or with tetragonal crystal structure. In some embodiments, a storage layer includes a magnetic junction layer or a spin Hall effect (SHE) layer. In some embodiments, a storage layer includes an anti-ferromagnetic layer. In some such embodiments, a storage layer is doped with and includes oxygen, nitrogen or heavy metal with large spin-flip length and small thermal mobility such as Ta, platinum (Pt), W, Mo, Co, Ni and others.

In some embodiments, a PCM cell includes a heating element, e.g., made of titanium nitride, and a phase-change storage material, such as chalcogenide glass. PCM storage layers need not include chalcogenides. In some embodiments, such a storage layer includes aluminum and antimony. Other materials may be used.

In some embodiments, a FeRAM cell includes a ferroelectric material with a high relative permittivity, such as a hafnium oxide in a ferroelectric phase. In some embodiments, a storage layer may include a 2D, ferroelectric material, such as an oxide of hafnium or a similar metal: hafnium, zirconium, and oxygen (HZO) (e.g., hafnium zirconium oxide, Hf₁₋ₓZrₓO₂); hafnium, titanium, and oxygen (e.g., hafnium titanium oxide, Hf₁₋ₓTiₓO₂); hafnium, scandium, and oxygen; zirconium and oxygen (e.g., zirconium dioxide, ZrO₂); niobium and oxygen, etc. In the case of hafnium oxide and similar ferroelectrics, ferroelectric phases may be achieved through the addition of a dopant, such as niobium, titanium, silicon, germanium, aluminum, yttrium, etc. In some embodiments, a storage layer includes lead, zirconium, titanium, and oxygen (e.g., lead zirconium titanate, Pb[ZrₓTi₁₋ₓ]O₃, (PZT)) or other perovskite materials, such as barium, titanium, and oxygen (e.g., barium titanate, BaTiO₃); lead, titanium, and oxygen (e.g., lead titanate, PbTiO₃); barium, strontium, titanium, and oxygen (e.g., barium strontium titanate, BaSrTiO₃); etc., for example. Other ferroelectric materials may be employed.

A metal target material layer may be deployed, for example, as a gate metal or as one of two conductive plates with a storage material layer between. The metal material layer may be of an elemental metal (such as Ti, Ta, Mo, W, ruthenium (Ru), Cu, Hf, Sr, Sn, In, Zn, etc.), a metallic compound (a titanium nitride, tantalum nitride, tungsten nitride, ruthenium oxide, titanium oxide, copper sulfide, copper selenide, etc.), a mixture within a layer, a combination of layers, etc., and may be chosen to accompany a material in a gate dielectric, storage material layer, etc. Multiple material layers may be employed, for example, with an interface layer adjacent a dielectric or storage material layer.

One or more mask material layers are formed over the one or more target material layers. The mask material layer(s) may include any suitable materials, including those conventionally used for hardmasks during IC fabrication. For example, mask material layers may include any suitable oxide, carbide, nitride, oxynitride, oxycarbide, etc., including metal-oxides and metal-nitrides. In some embodiments, mask material layers include silicon oxide, silicon nitride, silicon oxynitride, etc. Multiple mask material layers may be used to allow selective etches to remove a portion or all of one mask layer but retain another, e.g., because of selectivities with different etchants, such as oxygen- or halogen-rich plasmas. Some materials may be deployed in both a target material layer and a mask material layer.

The mask material layers may include a lithographic layer or stack. In many embodiments, a lithographic stack includes a bi- or tri-layer with one or two anti-reflective coatings (ARC) under a photoresist layer. The photoresist layer enables the optical transferring of a layout (or other) design to a mask pattern in a mask material layer in the substrate. One or more bottom or back ARCs (BARCs) may enhance optical resolution on the photoresist layer (enabling a better-resolved pattern in the photoresist layer), facilitate the transferring of the pattern into one or more lower layers by etching, and provide clean removability. In some embodiments, a two-layer BARC includes a pairing of organic and inorganic ARCs. For example, an inorganic (e.g., Si) ARC may be between a photoresist layer and a spin-on carbon (SOC) BARC layer. The inorganic (e.g., Si-ARC) layer may also be spun on. A halogen (e.g., fluorocarbon) plasma may be used to transfer a pattern from the photoresist, an oxygen-rich plasma from the Si-ARC, and another halogen-rich plasma etch from the SOC. Other materials may be employed in mask layers, including lithographic layers.

Methods 200 continue at operation 210 by patterning a first mask pattern with first and second mask features. Mask patterns may have multiple groups of mask features, and each group may have multiple mask features within. A first group of first mask material features may be those features of the first mask pattern with portions to be retained and transferred into one or more target material layers. Designs for the first mask pattern and a second mask pattern may be strategically coordinated such that a combined third mask pattern formed from an intersection of the patterns yield a final, retained feature (or array of features) in the target material layer(s). For example, first and second mask patterns can include groups of parallel segments arranged so that their intersections (e.g., where one segment overlaps another segment) form an array of structures having the shape of the overlapping portions.

A second group of second mask material features may be those features of the first mask pattern without portions to be retained and transferred into one or more target material layers, e.g., to be erasable. Any second mask material features will be printed in at least the first mask material, but may be removed with any non-intersected portions of the first mask material features (while one or more intersected (e.g., overlapped) portions of the first mask material features are retained under a second mask material layer). These erasable, dummification features may be used near the array (e.g., for micro loading) and/or away from the array (e.g., for macro loading, to fill otherwise blank fields).

Patterning a first mask pattern (and any other subsequent mask patterns) may be performed by any suitable means. In many embodiments, a designed pattern in a photomask is optically transferred into a layer of photoresist material, which can be etched into a mask pattern for transferring (e.g., by further etching) into other mask material layers. The photoresist material that is optically exposed to the designed pattern is weakened (or strengthened, depending on the photoresist material) by the exposure, and the exposed (or unexposed) portion can be removed (e.g., by a wet or dry etch selective to the strengthened or non-weakened portion(s)). A mask pattern is then retained.

FIG. 3A illustrates a stack 300 of layers in or on a substrate 310, for example, after operations 205 and 210 of methods 200. Stack 300 is in an IC die 399 and includes a first target material layer 320 over substrate 310, and a second target material layer 330 over first target layer 320. A first hardmask layer 340, a supplemental mask layer 350, a second hardmask layer 360, and a BARC layer 370 are over target layers 320, 330. First mask pattern 301 includes first mask material features 381 and second mask material features 383, 385 in a photoresist layer 380 over BARC layer 370.

First and second target layers 320, 330 may be much as previously described, for example, at operation 205. In the example of FIG. 3A, first target material layer 320 includes a semiconductor material, and second target material layer 330 includes a dielectric material.

An array of first mask material features 381 may later be overlapped by third mask material features, and overlapped portions may be retained. Second mask material features 383 are adjacent the array of first mask material features 381 on at least one side. Second mask material features 383 (not shown) may also be on a side opposite second mask material features 383 visible in FIG. 3A. Second mask material features 383 are parallel to, and have a pitch at least approximately equal to that of, first mask material features 381. Second mask material features 385 have a greater pitch and are perpendicular to first and second mask material features 381, 383. The greater pitch of second mask material features 385 may allow for interdigitating features of a second mask pattern in between second mask material features 385. Second mask material features 385 are on multiple sides of the array of first mask material features 381. Additional second mask material features 385 (not shown) may surround first mask material features 381.

Returning to FIG. 2, methods 200 continue with etching the first mask pattern into a lower mask material layer at operation 215. For example, the first mask pattern may be in a mask layer, such as a layer of photoresist, over one or more other mask material layers, including the first mask material layer. The first mask pattern may be transferred the first mask material layer by any suitable means, e.g., by one or more anisotropic etches selective to the mask material layer already having the first mask pattern. Such an etch may be as previously described, such as fluorocarbon-rich plasma etching a pattern from the photoresist into a Si-ARC layer. Such an etch may be one of a series of etches to transfer the first mask pattern into the first mask material layer. For example, after the pattern is etched into the Si-ARC from a photoresist layer, the photoresist layer may be selectively removed before an oxygen-rich plasma etches the pattern from a Si-ARC layer to a SOC layer below. The Si-ARC layer may then be selectively removed, and so on, until an etch has transferred the first mask pattern into the first mask material layer. This series of etches shows how different mask materials and etchants may be chosen, e.g., with different etch resistances and selectivities.

FIG. 3B shows first mask pattern 301 in stack 300 much as in FIG. 3A, but with layers 360, 370, 380 absent, for example, after multiple iterations of operation 215 of methods 200. First mask pattern 301 includes first mask material features 351 and second mask material features 353, 355 in supplemental mask layer 350.

Methods 200 continue at optional operation 220 with increasing a lateral dimension of mask features by depositing a conformal layer over the stack. A conformal layer may be deposited over the first mask pattern and the stack of layers such that the lateral dimensions of features (e.g., in the x-y plane) are increased by the thickness of the conformally deposited layer. The conformal layer may deposit on vertical surfaces (e.g., sidewalls) and increase the lateral dimensions (e.g., widths and lengths) of all exposed, printed features in the substrate (e.g., both the first and second mask material features). The conformal layer will also deposit on horizontal surfaces, which may raise the material levels at both the base and top of exposed, printed features and keep feature heights substantially constant.

Wider or longer first mask material features will result in correspondingly larger areas of overlapped portions by the third mask material features of a second mask pattern.

FIG. 3C illustrates first mask pattern 301 in stack 300 much as in FIG. 3B, but with conformal spacer layer 390 over pattern 301, for example, after operation 220. First mask pattern 301 includes first mask material features 391 and second mask material features 393, 395 in layer 390 (which internally contain features 351, 353, 355). In some embodiments, spacer layer 390 has a same composition as supplemental mask layer 350. In some such embodiments, there is no distinguishable border or interface between layers 350, 390, and features 391, 393, 395 are features 351, 353, 355.

First mask pattern 301 has wider and longer features 391, 393, 395 than first mask pattern 301 of FIG. 3B (with features 351, 353, 355). First mask pattern 301 may be considered the same first mask pattern 301 with larger features. In some embodiments, first mask pattern 301 may be considered modified sufficiently to be a distinct mask pattern 301B.

FIG. 3D shows first mask pattern 301 in stack 300 much as in FIG. 3C, but with first mask pattern 301 in first hardmask layer 340 and most of layers 350, 390 absent, for example, after another iteration of operation 215. As an example, first mask pattern 301 may be in first hardmask layer 340 following an anisotropic etch that has removed all of layer 390 but the portions of layer 390 that were below, and masked from above by, portions of layer 390 on sidewalls of features 351, 353, 355. Likewise, all of layer 350 may have been removed by an anisotropic etch but for the portions of layer 350 that were below, and masked from above by, bulk portions of features 351, 353, 355. Portions of second target material layer 330 are unmasked, exposed and available for subsequent etching.

First mask pattern 301 includes first mask material features 341 and second mask material features 343, 345, which have the wider and longer dimensions of features 391, 393, 395. In some embodiments, layers 350, 390 have a shared composition and are indistinguishable, and features 341, 343, 345 are masked only by features 351, 353, 355.

Returning to FIG. 2, methods 200 continue by forming a second mask material layer over the first mask pattern at operation 225. A second mask material layer may be formed by any suitable means. In some embodiments, a second mask material layer is formed similarly to the first mask material layer, although first and second mask material layers may be of different mask materials to enable separate or distinct processing of the first and second mask material layers and the first and second mask patterns. In some embodiments, a second mask material layer is formed similarly to a portion of the stack formed at operation 205. In some such embodiments, a second mask material layer is formed as part of a lithographic stack over the first mask pattern, e.g., in the first mask material layer.

Methods 200 continue at operation 230 with patterning a second mask pattern with third and fourth mask features. Mask patterns may have multiple groups of mask features, and each group may have multiple mask features within. A third group of third mask material features may be those features of the second mask pattern with portions to be retained and transferred into one or more target material layers, e.g., by overlapping with first mask material features of the first mask pattern. Designs for the first mask pattern and a second mask pattern may be strategically coordinated such that a combined third mask pattern formed from an intersection of the patterns yield a final, retained feature (or array of features) in the target material layer(s). For example, a first mask pattern may include a group of regularly spaced, parallel first segments extending in a first direction, and a second mask pattern may include a group of regularly spaced, parallel second segments extending in a second direction perpendicular to the first direction. The first and second mask patterns may be arranged so that the first and second segments overlap, and their regular intersections (e.g., where second segments overlap first segments) form a grid array of rectangular structures.

A fourth group of fourth mask material features may be those features of the second mask pattern adjacent the third mask material features and without portions to be retained and transferred into one or more target material layers, e.g., to not overlap any of the first or the second mask material features, and to be entirely erasable. Any fourth mask material features will be printed in at least the second mask material, but may be removed with the rest of the second mask material features (e.g., without being transferred into a target material layer). These erasable, dummification features may be used near the array (e.g., for micro loading) and/or away from the array (e.g., for macro loading, to fill otherwise blank fields). In some embodiments, a fourth mask material feature of the second mask pattern is parallel to a second mask material feature of the first mask pattern. In some embodiments, a fourth mask material feature of the second mask pattern is perpendicular to a second mask material feature of the first mask pattern.

FIG. 3E illustrates stack 300 with second mask pattern 302 in photoresist layer 380, for example, after operations 225 and 230. Second mask pattern 302 includes third mask material features 382 and fourth mask material features 384, 386. An array of third mask material features 382 may overlap first mask material features 341, and overlapped portions may be retained. Fourth mask material features 384 are adjacent the array of third mask material features 382 on at least one side. Fourth mask material features 384 (not shown) may also be on a side opposite fourth mask material features 384 visible in FIG. 3E. Fourth mask material features 384 are parallel to, and have a pitch at least approximately equal to that of, third mask material features 382. Fourth mask material features 386 have a greater pitch and are parallel to third and fourth mask material features 382, 384. The greater pitch of fourth mask material features 386 may allow for interdigitating second mask material features 385 in between fourth mask material features 386. Fourth mask material features 386 are on multiple sides of the array of third mask material features 382. Additional fourth mask material features 386 (not shown) may surround third mask material features 382.

FIG. 3F shows second mask pattern 302 in stack 300 much as in FIG. 3E, but with conformal spacer layer 390 over pattern 302, for example, after another iteration of operation 220. Second mask pattern 302 includes third mask material features 392 and fourth mask material features 394, 396 in layer 390 (which internally contain features 382, 384, 386). In some embodiments, spacer layer 390 has a same composition as previous spacer layer 390 (e.g., in FIG. 3C) or supplemental mask layer 350. Second mask pattern 302 has wider and longer features 392, 394, 396 than second mask pattern 302 of FIG. 3E (with features 382, 384, 386). Second mask pattern 302 may be considered the same second mask pattern 302 with larger features. In some embodiments, second mask pattern 302 may be considered modified sufficiently to be a distinct mask pattern 302B.

Returning to FIG. 2, methods 200 continue with etching the second mask pattern into a lower mask material layer at operation 235. Etching the second mask pattern into a lower mask material layer may be similar to, or the same as, some embodiments of etching the first mask pattern into a lower mask material layer at operation 215. For example, multiple etches may be employed to transfer the second mask pattern into a lower mask material layer. In some embodiments, one or more etches at operation 235 are the same as, or similar to, one or more etches at operation 215. In some such embodiments, one or more etches at operation 235 are of a lithographic stack employed at operation 215.

FIG. 3G illustrates second mask pattern 302 in stack 300, but with layer 380 absent and with second mask pattern 302 transferred into layers 360, 370, for example, after multiple iterations of operation 235 of methods 200. Second mask pattern 302 includes third mask material features 362 and fourth mask material features 364, 366 in layer 360, masked by third mask material features 372 and fourth mask material features 374, 376 in BARC layer 370. No unmasked portions of second hardmask layer 360 remain, and non-overlapped portions of first mask pattern 301 are exposed.

Second mask material features 343, 345 of first mask pattern 301 are non-intersected or -overlapped by second mask pattern 302. Features 343, 345 of first mask pattern 301 are masked by second mask material features 353, 355. Features 353, 355 are exposed, non-intersected or - overlapped portions of first mask pattern 301. First mask pattern 301 includes first mask material features 341, 351. Non-intersected or -overlapped portions of features 341 (e.g., between features 362 and at ends of features 341) are masked by features 351. Intersected portions of features 341, 351 are covered by overlapping portions of third mask material features 362, 372 of second mask pattern 302.

Portions of second target material layer 330 are again unmasked, exposed and available for subsequent etching.

Returning to FIG. 2, methods 200 continue by removing any intermediate mask material layers at operation 240. Intermediate mask materials may be removed by any suitable means. In some embodiments, selective etch is employed to remove an intermediate mask material layer without substantially removing any other material. In some embodiments, a less-selective anisotropic etch is employed. ISEE, such a directional etch erodes an underlying material layer somewhat. In some embodiments, a removal etch creates residual substrate marks, such as indentations or depressions in substantially parallel stripes, which form latent images of the removed features on the material layer below.

FIG. 3H shows overlapping first and second mask patterns 301, 302 in stack 300, much as in FIG. 3G, but with layer 370 (and most of layer 350) absent, for example, after operation 240. An "AND"-ed grid array of overlapped (or intersected), rectangular portions of first mask material features 359 are over intersected portions of first mask material features 341. Non-overlapped portions of first mask material features 341 are unmasked, exposed and available for subsequent etching, as are all of second mask material features 343, 345.

Methods 200 continue at operation 245 with forming a third mask pattern with an etch of the second mask pattern into the first mask pattern, which removes the second mask feature. An etch selective to the third and fourth mask material features of the second mask pattern may be utilized to remove non-overlapped portions of the first mask pattern, including all of the second mask material features. Non-overlapped portions of the first mask material features may also be removed, while overlapped portions of the first mask material features may be retained. These retained, intersected portions of the first mask material features are a third mask pattern. In some embodiments, the third mask pattern in a first mask material layer is still covered by overlapping portions of the second mask pattern, e.g., in a second mask material layer.

This removal etch may bombard a target material (or other) layer and form indentations or depressions in the shape of erased features. In some embodiments, a removal etch creates residual substrate marks, such as indentations or depressions in substantially parallel stripes, which form latent images of the removed features (e.g., second mask material features) on the material layer below.

FIG. 3I illustrates overlapping second and third mask patterns 302, 303 in stack 300, with non-overlapped portions of first mask pattern 301 absent, for example, after operation 245. Second mask pattern 302 includes third mask material features 362 and fourth mask material features 364, 366. Third mask material features 362 overlap first mask material features 349, 359 of third mask pattern 303. A footprint of third mask pattern 303 is a subset of second mask pattern 302.

Latent images 337 are marks in layer 330, such as indentations or depressions in substantially parallel stripes, between features, some of which have been removed.

Methods 200 continue with removing the second mask material layer, including the fourth mask feature at operation 250. The second mask material layer may be removed by any suitable means. In some embodiments, selective etch is employed to remove the second mask material layer without substantially removing any other material. In some embodiments, a less-selective anisotropic etch is employed. ISEE, such a directional etch erodes an underlying material layer somewhat. In some embodiments, a removal etch creates residual substrate marks, such as indentations or depressions in substantially parallel stripes, which form latent images of the removed features on the material layer below.

Removing the second mask material layer reveals the third mask pattern, which is the intersection(s) of the first and second mask patterns. In some embodiments, the first mask pattern includes a first mask material feature having a first segment extending in a first direction, and the second mask pattern includes a third mask material feature having an overlapping second segment extending in a second direction perpendicular to the first direction. In such embodiments, the intersecting portion in the third mask pattern is a rectangular region located where the first and second segments overlap. In some such embodiments, the first mask pattern and first mask material feature(s) have a group of first segments, regularly spaced and extending in the first direction, and the second mask pattern and third mask material feature(s) have a group of overlapping second segments extending in the second direction. In some such embodiments, the intersecting portion in the third mask pattern is a regular, perpendicular grid of rectangular regions located where the groups of first and second segments overlap.

FIG. 3J shows third mask pattern 303 in stack 300, with fourth mask material features 364, 366 and non-overlapped portions of third mask material features 362 absent, for example, after operation 250.

Additional and/or more severe latent images 337 are marks in layer 330, such as indentations or depressions in substantially parallel stripes, e.g., between removed features.

Methods 200 continue at operation 255 by etching the target material layer with the third mask pattern. With the third mask pattern developed and the other portions of the first and second mask patterns removed, the third mask pattern may be used to etch a target material layer. Any suitable etch may be employed, e.g., an etch selective to the mask material layer of the third mask pattern and to which the target material layer is not resistant. In many embodiments, a dry, anisotropic etch is utilized. In some embodiments, the target material layer is etched at least partially through using the third mask pattern. In some embodiments, the etch continues entirely through the target material layer and etching into an underlying substrate material layer. In some such embodiments, the etch is entirely through a first target material layer and into an underlying second target material layer. In some embodiments, the third mask pattern includes a rectangular region at the intersection of first and second perpendicular segments, and this third mask pattern is etched into a target material layer. In some such embodiments, the intersecting portion in the third mask pattern is a regular, perpendicular grid of rectangular regions located where the groups of first and second segments overlap, and this third mask pattern is etched into a target material layer.

In some embodiments, a directional etch erodes an underlying or substrate material layer somewhat. In some embodiments, a removal etch creates residual substrate marks, such as indentations or depressions in substantially parallel stripes, which form latent images of the removed features on the material layer below. In some embodiments, latent images are transferred from a material layer to an underlying or substrate material layer as already eroded, indented, or depressed regions are subsequently more easily eroded than more planar surfaces that are relatively intact. Previously over-etched, eroded, indented, or depressed regions in one layer may again be over-etched, eroded, indented, or depressed regions in a lower layer.

FIG. 3K illustrates third mask pattern 303 in first hardmask layer 340 and second target material layer 330 of stack 300, for example, after operation 255. Supplemental mask layer 350 and features 359 are absent. The non-overlapping portions of first and third mask material features are absent (as in FIG. 3J). Most of second target material layer 330 is absent, and only third mask pattern 303 is in second target material layer 330. The third mask pattern 303 is a regular, perpendicular grid array of rectangular cells 339, 349.

Portions of first target material layer 320 are unmasked, exposed and available for subsequent etching.

Latent images 327 are marks in layer 320, such as indentations or depressions in substantially parallel stripes, e.g., between removed features.

FIG. 3L shows third mask pattern 303 in first and second target material layers 320, 330 of IC die 399, for example, after another iteration of operation 255. Hardmask layer 340 and features 349 are absent. Most of first and second target material layers 320, 330 are absent, and only third mask pattern 303 and features 329, 339 are in first and second target material layers 320, 330. The third mask pattern 303 is a regular, perpendicular grid array 304 of rectangular features 329, 339. Cells 305 include rectangular features 329, 339. In the example of FIG. 3L, first target material layer 320 and features 329 include a semiconductor material, second target material layer 330 and features 339 include a dielectric material, and cells 305 are 1T-1C DRAM cells.

Portions of substrate 310 are unmasked, exposed and available for subsequent etching.

Latent images 317 are marks in substrate 310, such as indentations or depressions in substantially parallel stripes, e.g., between removed features.

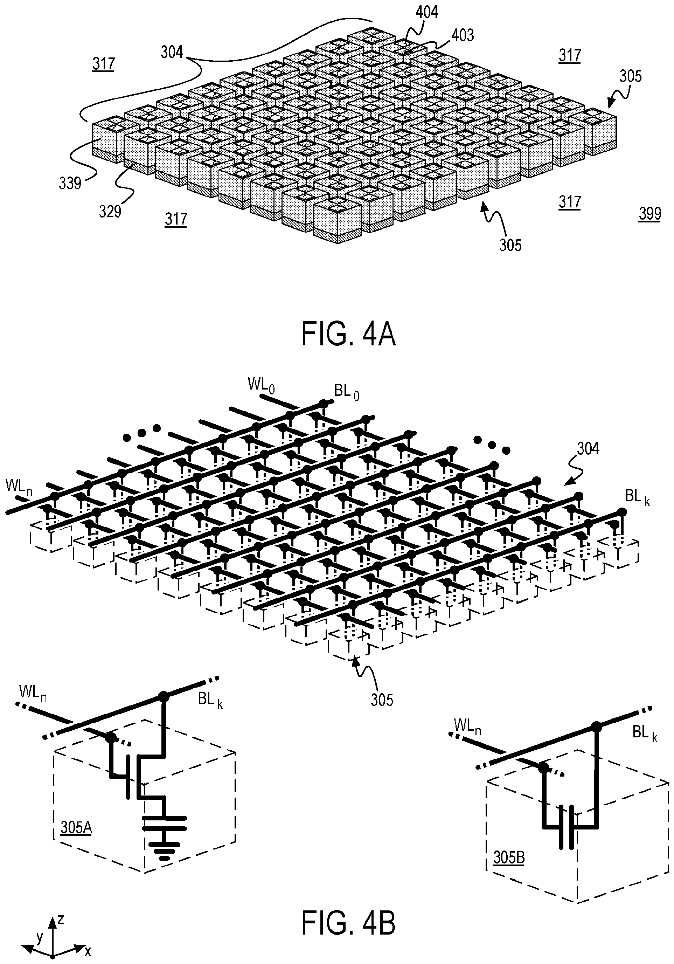

FIGS. 4A and 4B illustrate isometric and schematic views of array 304 of memory cells 305, in accordance with some embodiments. FIG. 4A shows memory cells 305, which are rectangular structures and may employ any of various suitable memory schemes, including those referenced at operation 205 of methods 200 and FIG. 2. In some embodiments, cells 305 include more than layers 329, 339. Individual memory cells 305 in array 304 may be accessed by wordlines and bitlines. Cells 305 include at least wordline connections 403 and bitline connections 404. Array 304 and cells 305 may include other interconnections or metallization, e.g., more wordlines and bitlines, such as dedicated read and write bitlines, etc. In some embodiments, array 304 and cells 305 may include other, e.g., ground (or other) lines. In some such embodiments, some such lines are between cells 305. Adjacent latent images 317 may be substantially parallel stripes of indentations or depressions in a substrate including cells 305.

FIG. 4B illustrates an example interconnection scheme. In the example of FIG. 4A, memory cells 305 are 1T-1C cells with a single transistor and single capacitor per cell, as is shown schematically by cell 305A in FIG. 4B. A data bit is stored in the capacitor of each cell 305A and accessed by the corresponding transistor. To read from or write to the capacitor of cell 305A, the transistor is selected or accessed by controlling the wordline WLₙ electrically connected to the gate of the transistor. When a cell is accessed, its bit is connected to the corresponding bitline BLₖ. Other schemes may be employed.

In some embodiments, array 304 is of memory cells 305B, which store data in a storage material between two conductive plates. For example, ferroelectric RAM (FeRAM) devices may store data in ferroelectric capacitors. Charge-trap memory may use, e.g., oxide and nitride layers between two conductive plates. Resistive RAM (ReRAM), magnetoresistive RAM (MRAM), phase-change memory (PCM) (or phase-change RAM (PRAM)), and other types of memory devices can be used.

Array 304 and/or memory cells 305B may employ appropriate schemes for accessing and/or storing data. For example, a single transistor may control a row or column of cells, and two transistors may be used to control orthogonal control lines and select and read from or write to a single cell. In some embodiments, a wordline accesses a word on a single transistor's plateline, e.g., with multiple cells sharing a plateline, but each cap having a separate bitline on another plate. Zero-capacitor cells may employ one or more transistors their parasitic or body capacitance rather than plates sandwiching a dielectric. Other embodiments may employ yet other structures.

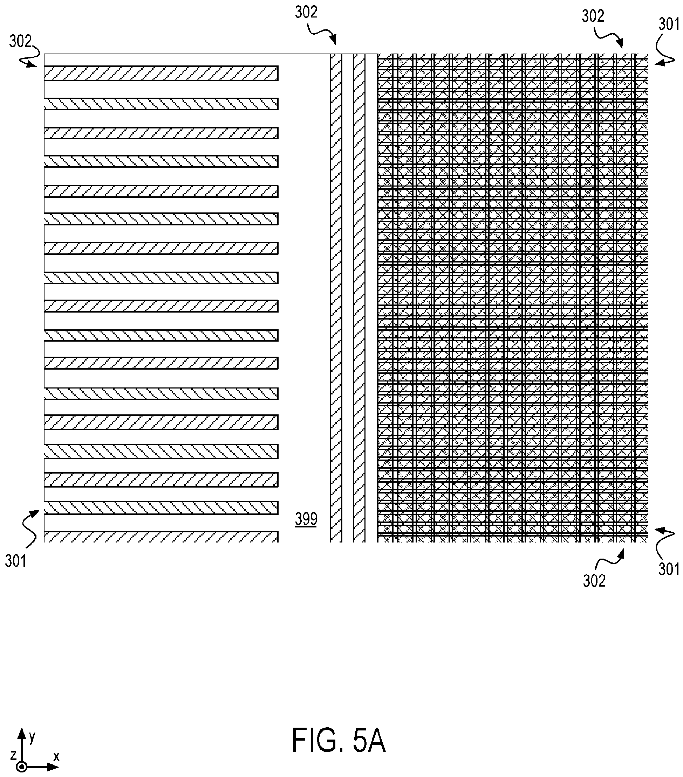

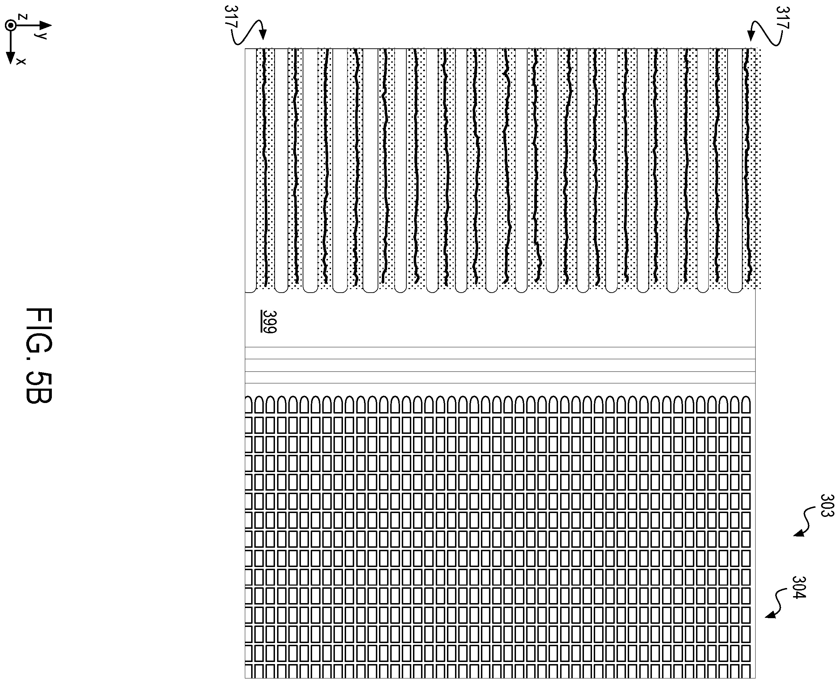

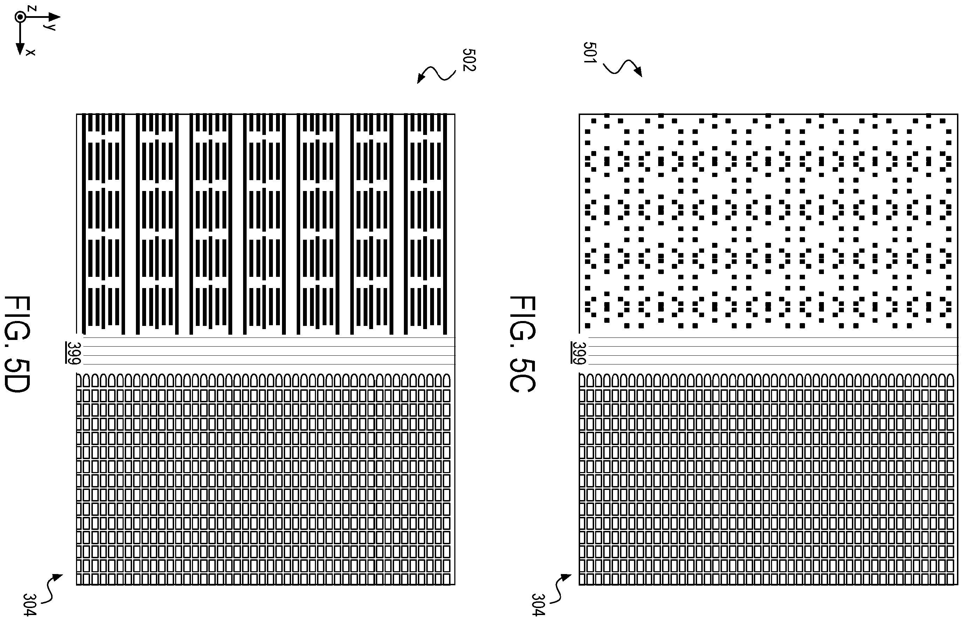

FIGS. 5A, 5B, 5C, and 5D illustrate plan views of IC die 399 with an array 304 of memory cells adjacent logic routing 501, 502, in accordance with some embodiments. FIG. 5A shows first and second mask patterns 301, 302, including arrays of overlapping perpendicular features, near-array dummy features (in pattern 302) for maintaining local micro loading, and interdigitated features for improved wafer macro loading and end-point control. Patterns 301, 302, 303 may be in an interconnect layer over logic resources in a layer below.

FIG. 5B illustrates IC die after third mask pattern 303 has been used to form array 304, and dummy features have been erased. Latent images 317 are parallel stripes of indentations or depressions in IC die 399, e.g., residual substrate marks from over-etch erosion when erasing dummification.

FIGS. 5C and 5D show logic routing 501, 502 adjacent array 304 in an interconnect layer of IC die 399. Via routing 501 in FIG. 5C may electrically connect to transistor (e.g., CMOS) structures in a layer below. Trench routing 502 in FIG. 5D may electrically connect to the between-layer vias shown in FIG. 5C.

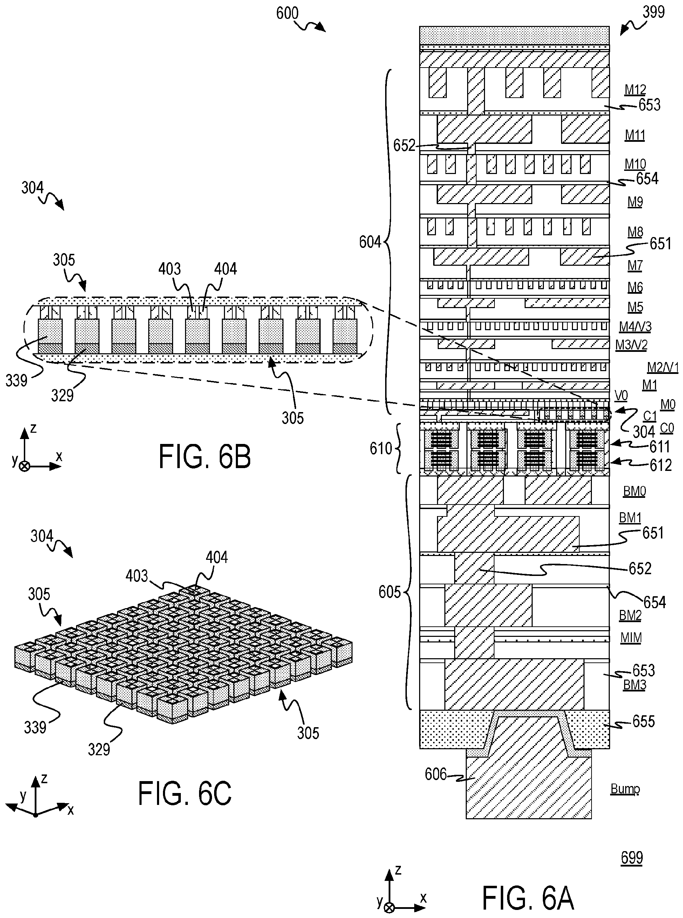

FIGS. 6A, 6B, and 6C illustrate cross-sectional profile and isometric views of array 304 of embedded memory cells 305 in an interconnect layer of IC die 399, over arrays of transistor structures 611, 612, in accordance with some embodiments. FIG. 6A shows a cross-sectional view of an IC device 600 having array 304 of memory cells 305 in front-side or back-side interconnect layers 604, 605. FIGS. 6B and 6C illustrate magnified cross-sectional profile and isometric views of array 304 of embedded memory cells 305. Cells 305 include material layers 329, 339. Cells 305 are interconnected, e.g., to signal routing, via wordline connections 403 and bitline connections 404.

In the example of IC device 600, array 304 of memory cells 305 is deployed in front-side interconnect layers 604. Array 304 and memory cells 305 are shown magnified, e.g., for clarity, including in FIG. 6B. Memory cells 305 are over groups or arrays of transistor structures 611, 612 in at least one device layer 610. In the example of IC device 600, memory cells 305 are in a layer directly over device layer 610. Additionally or in the alternative, memory cells 305 may be deployed in one or more other layers, e.g., M0, M1, etc., and/or in device layer 610. Memory cells 305 may be interconnected to layers at a same level with, above, and/or below cells 305. Memory cells 305 may be deployed in front-side or back-side locations. Memory cells 305 may be formed at any suitable stage, e.g., front-end-of-line (FEOL), middle-of-line (MOL), back-end-of-line (BEOL), etc.

In FIG. 6A, IC device 600 includes an IC die 399, which is a monolithic IC with memory cells 305 as described above, including front-side metallization layers 604 (or front-side interconnect layers), optional back-side metallization layers 605 (or back-side interconnect layers), and transistor structures 611, 612 in at least device layer 610. IC device 600 includes a lateral surface along the x-y plane that may be defined or taken at any vertical position of IC device 600. The lateral surface of the x-y plane is orthogonal to a vertical or build-up dimension as defined by the z-axis. In some embodiments, front-side metallization layers 604 provide signal routing to device layer 610, and back-side metallization layers 605 provide power delivery to device layer 610. IC device 600 may also be deployed without back-side metallization layers 605 shown in FIG. 6A. In such embodiments, signal routing and power are provided to device layer 610 via front-side metallization layers 604. However, use of back-side metallization layers 605 may offer advantages.

Transistor structures 611, 612 are shown having channel regions in nanoribbons, which couple with source and drain terminals and are coupled to gate structures. In some embodiments, the nanoribbons may be narrower and may be characterized as nanowires. In other embodiments, the nanoribbons may be wider and may be characterized as nanosheets. In some embodiments, at least one of transistor structures 611, 612 are other non-planar transistor structures, e.g., having channel regions in fins, etc. In some embodiments, at least one of transistor structures 611, 612 are planar transistor structures. In some embodiments, transistor structures 612 are in a device layer under transistor structures 611 in device layer 610 (or in a portion of device layer 610 under the portion of device layer 610 having transistor structures 611). In some embodiments, IC die 399 includes one group of transistor structures 611, 612, e.g., transistor structures 611, but not transistor structures 612. In some embodiments, transistor structures are deployed in front-side and back-side interconnect layers 604, 605.

Interconnectivity of transistor structures 611, 612 (and other transistors, etc.), signal routing to and from device layer 610, etc., power delivery to device layer 610, etc., and routing to an outside device (not shown), is provided by front-side metallization layers 604, optional back-side metallization layers 605, and package-level interconnects 606. In the example of FIG. 6A, package-level interconnects 606 are provided on or over a back-side of IC die 399 as bumps over a passivation layer 655, and IC device 600 is coupled to host component 699 (and coupled to signal routing to, power delivery from a power supply, etc.) by package-level interconnects 606. However, package-level interconnects 606 may be provided using any suitable interconnect structures such as bond pads, solder bumps, etc. Furthermore, in some embodiments, package-level interconnects 606 are provided on or over a front-side of IC die 399 (i.e., over front-side metallization layers 604).

As used herein, the term "metallization layer" or "interconnect layer" describes layers primarily with interconnections or wires that provide electrical routing, generally formed of metal or other electrically conductive material. Adjacent metallization layers may be formed of different materials and by different methods. Metallization and interconnect layers may generally be over a device layer, e.g., device layer 610, including in a stack of multiple interconnect layers over a device layer. A device layer may include metallization and other interconnect features, but a device layer may be the layer, or one of the two or few layers, containing the all or the majority of the transistors in an IC die. A device layer may be at or adjacent a base from which both the front- and back-sides are built up (e.g., first in one direction and then the opposite). While transistors are often not deployed in layers meant primarily for interconnections, transistor structures may be deployed in metallization layers over device layers, including in memory cells 305, as described. Adjacent metallization layers, such as metallization interconnects 651, are interconnected by vias, such as vias 652, that may be characterized as part of the metallization layers or between the metallization layers. As shown, in some embodiments, front-side metallization layers 604 are formed over and immediately adjacent memory cells 305. The back-side is then the opposite side, which may be exposed during processing by attaching the front-side to a carrier wafer and exposing the back-side (e.g., by back-side grind or etch operations) as known in the art.

In the illustrated example, front-side metallization layers 604 include M0, V0, M1, M2/V1, M3/V2, M4/V3, and M4-M12. However, front-side metallization layers 604 may include any number of metallization layers such as eight or more metallization layers. Similarly, back-side metallization layers 605 include BM0, BM1, BM2, and BM3. However, back-side metallization layers 605 may include any number of metallization layers such as two to five metallization layers. Front-side metallization layers 604 and back-side metallization layers 605 are embedded within dielectric materials 653, 654. Furthermore, optional metal-insulator-metal (MIM) devices, such as diode devices, may be provided within back-side metallization layers 605. Other devices such as capacitive memory devices may be provided within front-side metallization layers 604 and/or back-side metallization layers 605.

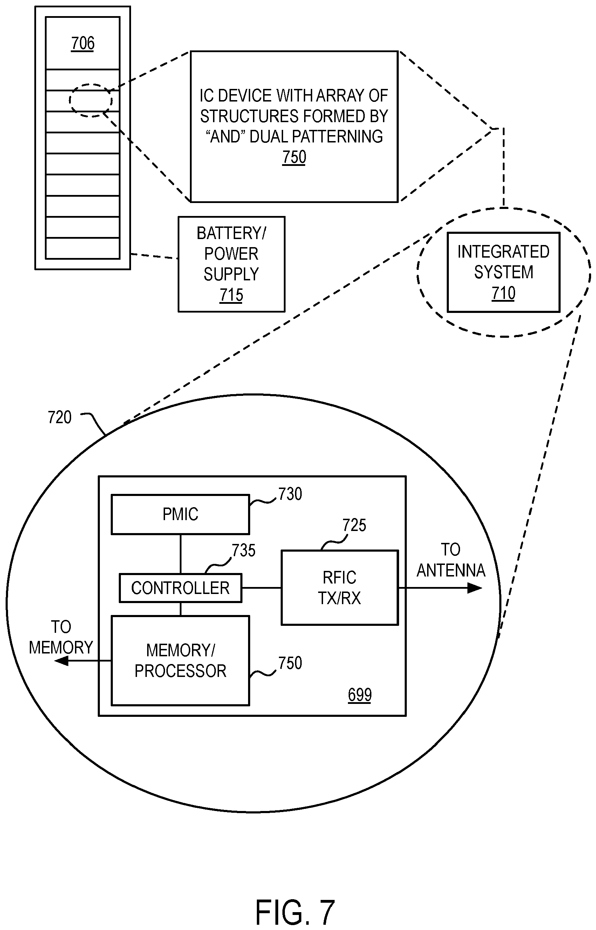

FIG. 7 illustrates a diagram of an example data server machine 706 employing an IC device having an array of structures formed with "AND" dual patterning, in accordance with some embodiments. Server machine 706 may be any commercial server, for example, including any number of high-performance computing platforms disposed within a rack and networked together for electronic data processing, which in the exemplary embodiment includes one or more devices 750 having an array of structures formed with "AND" dual patterning.

Also as shown, server machine 706 includes a battery and/or power supply 715 to provide power to devices 750, and to provide, in some embodiments, power delivery functions such as power regulation. Devices 750 may be deployed as part of a package-level integrated system 710. Integrated system 710 is further illustrated in the expanded view 720. In the exemplary embodiment, devices 750 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 750 is a microprocessor including a static RAM (SRAM) cache memory. As shown, device 750 may be an IC device having an array of structures formed with "AND" dual patterning, as discussed herein. Device 750 may be further coupled to (e.g., communicatively coupled to) a board, an interposer, or a substrate 699 along with, one or more of a power management IC (PMIC) 730, RF (wireless) IC (RFIC) 725 including a wideband RF (wireless) transmitter and/or receiver (TX/RX) (e.g., including a digital baseband and an analog front end module further includes a power amplifier on a transmit path and a low noise amplifier on a receive path), and a controller 735 thereof. In some embodiments, RFIC 725, PMIC 730, controller 735, and device 750 include an array of structures formed with "AND" dual patterning.

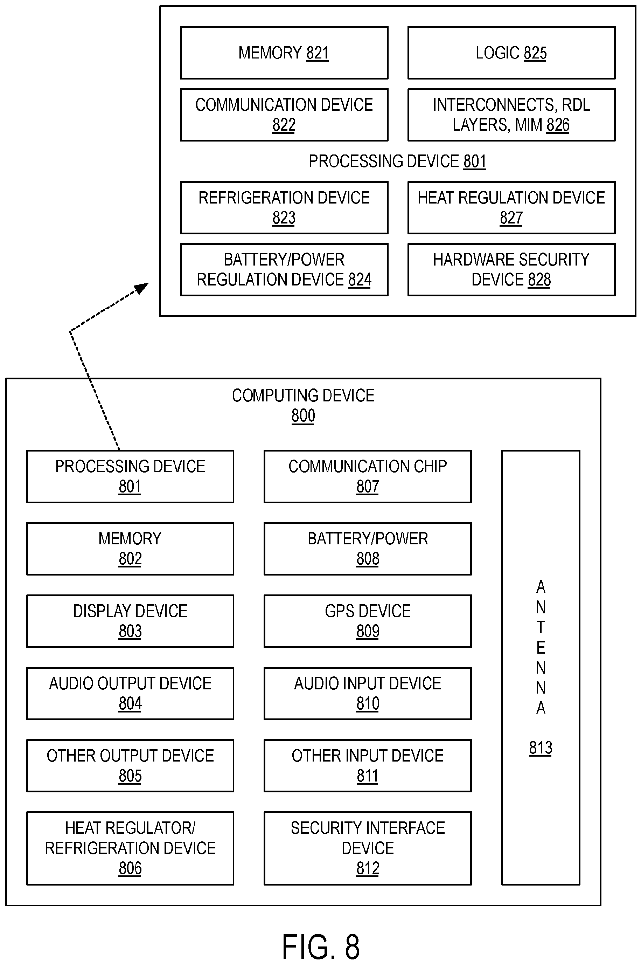

FIG. 8 is a block diagram of an example computing device 800, in accordance with some embodiments. For example, one or more components of computing device 800 may include any of the devices or structures discussed herein. A number of components are illustrated in FIG. 8 as being included in computing device 800, but any one or more of these components may be omitted or duplicated, as suitable for the application. In some embodiments, some or all of the components included in computing device 800 may be attached to one or more printed circuit boards (e.g., a motherboard). In some embodiments, various ones of these components may be fabricated onto a single system-on-a-chip (SoC) die. Additionally, in various embodiments, computing device 800 may not include one or more of the components illustrated in FIG. 8, but computing device 800 may include interface circuitry for coupling to the one or more components. For example, computing device 800 may not include a display device 803, but may include display device interface circuitry (e.g., a connector and driver circuitry) to which display device 803 may be coupled. In another set of examples, computing device 800 may not include an audio output device 804, other output device 805, global positioning system (GPS) device 809, audio input device 810, or other input device 811, but may include audio output device interface circuitry, other output device interface circuitry, GPS device interface circuitry, audio input device interface circuitry, audio input device interface circuitry, to which audio output device 804, other output device 805, GPS device 809, audio input device 810, or other input device 811 may be coupled.

Computing device 800 may include a processing device 801 (e.g., one or more processing devices). As used herein, the term "processing device" or "processor" indicates a device that processes electronic data from registers and/or memory to transform that electronic data into other electronic data that may be stored in registers and/or memory. Processing device 801 may include a memory 821, a communication device 822, a refrigeration device 823, a battery/power regulation device 824, logic 825, interconnects 826 (i.e., optionally including redistribution layers (RDL) or metal-insulator-metal (MIM) devices), a heat regulation device 827, and a hardware security device 828.

Processing device 801 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 800 may include a memory 802, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 802 includes memory that shares a die with processing device 801. This memory may be used as cache memory and may include embedded dynamic random-access memory (eDRAM) or spin transfer torque magnetic random-access memory (STT-MRAM).

Computing device 800 may include a heat regulation/refrigeration device 806. Heat regulation/refrigeration device 806 may maintain processing device 801 (and/or other components of computing device 800) at a predetermined low temperature during operation.

In some embodiments, computing device 800 may include a communication chip 807 (e.g., one or more communication chips). For example, the communication chip 807 may be configured for managing wireless communications for the transfer of data to and from computing device 800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 807 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 807 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 807 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 807 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 807 may operate in accordance with other wireless protocols in other embodiments. Computing device 800 may include an antenna 813 to facilitate wireless communications and/or to receive other wireless communications (such as AM or FM radio transmissions).

In some embodiments, communication chip 807 may manage wired communications, such as electrical, optical, or any other suitable communication protocols (e.g., the Ethernet). As noted above, communication chip 807 may include multiple communication chips. For instance, a first communication chip 807 may be dedicated to shorter-range wireless communications such as Wi-Fi or Bluetooth, and a second communication chip 807 may be dedicated to longer-range wireless communications such as GPS, EDGE, GPRS, CDMA, WiMAX, LTE, EV-DO, or others. In some embodiments, a first communication chip 807 may be dedicated to wireless communications, and a second communication chip 807 may be dedicated to wired communications.

Computing device 800 may include battery/power circuitry 808. Battery/power circuitry 808 may include one or more energy storage devices (e.g., batteries or capacitors) and/or circuitry for coupling components of computing device 800 to an energy source separate from computing device 800 (e.g., AC line power).

Computing device 800 may include a display device 803 (or corresponding interface circuitry, as discussed above). Display device 803 may include any visual indicators, such as a heads-up display, a computer monitor, a projector, a touchscreen display, a liquid crystal display (LCD), a light-emitting diode display, or a flat panel display, for example.

Computing device 800 may include an audio output device 804 (or corresponding interface circuitry, as discussed above). Audio output device 804 may include any device that generates an audible indicator, such as speakers, headsets, or earbuds, for example.

Computing device 800 may include an audio input device 810 (or corresponding interface circuitry, as discussed above). Audio input device 810 may include any device that generates a signal representative of a sound, such as microphones, microphone arrays, or digital instruments (e.g., instruments having a musical instrument digital interface (MIDI) output).

Computing device 800 may include a GPS device 809 (or corresponding interface circuitry, as discussed above). GPS device 809 may be in communication with a satellite-based system and may receive a location of computing device 800, as known in the art.

Computing device 800 may include other output device 805 (or corresponding interface circuitry, as discussed above). Examples of the other output device 805 may include an audio codec, a video codec, a printer, a wired or wireless transmitter for providing information to other devices, or an additional storage device.

Computing device 800 may include other input device 811 (or corresponding interface circuitry, as discussed above). Examples of the other input device 811 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 800 may include a security interface device 812. Security interface device 812 may include any device that provides security measures for computing device 800 such as intrusion detection, biometric validation, security encode or decode, access list management, malware detection, or spyware detection.

Computing device 800, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1-8. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes an IC die, an array of structures on a layer of the IC die, a first plurality of substantially parallel first stripes in the layer and adjacent the array, wherein individual ones of the first stripes include first indentations in the layer, and a second plurality of substantially parallel second stripes including second indentations in the layer and adjacent the array.

In one or more second embodiments, further to the first embodiments, the first stripes are substantially perpendicular to the second stripes.

In one or more third embodiments, further to the first or second embodiments, the IC die includes a plurality of transistor structures at a same level with, or below, the plurality of substantially parallel stripes.

In one or more fourth embodiments, further to the first through third embodiments, the IC die includes a first interconnect structure over the layer and a second interconnect structure under the layer.

In one or more fifth embodiments, further to the first through fourth embodiments, an individual one of the structures includes a transistor structure and a capacitor.

In one or more sixth embodiments, further to the first through fifth embodiments, the array includes the structures arranged in a grid of substantially perpendicular columns and rows.

In one or more seventh embodiments, an apparatus includes an IC die, a first plurality of depressions in a layer of the IC die, wherein the depressions extend substantially in a first direction, a second plurality of depressions in the layer, wherein the second plurality of depressions extend in a second direction substantially perpendicular to the first direction, and an array of structures in the layer and adjacent the first and second pluralities of depressions.

In one or more eighth embodiments, further to the seventh embodiments, the first plurality of depressions is over a transistor structure.

In one or more ninth embodiments, further to the seventh or eighth embodiments, the array of structures is arranged in a grid of substantially perpendicular columns and rows.

In one or more tenth embodiments, further to the seventh through ninth embodiments, an individual one of the structures includes a capacitor.

In one or more eleventh embodiments, a method including forming a mask material layer over a target material layer of a substrate, forming, with a first etch of the mask material layer, a first mask pattern including a first mask material feature adjacent to a second mask material feature, forming a second mask pattern including a third mask material feature, wherein the third mask material feature overlaps an intersected portion of the first mask material feature, forming, with a second etch of the mask material layer, a third mask pattern, the second etch retaining the intersected portion of the first mask material feature and removing substantially all of the second mask material feature, and etching at least partially through the target material layer based on the third mask pattern.

In one or more twelfth embodiments, further to the eleventh embodiments, the method also includes etching entirely through the target material layer and etching into an underlying substrate material layer.

In one or more thirteenth embodiments, further to the eleventh or twelfth embodiments, removing substantially all of the second mask material feature leaves a latent image in the substrate material layer, the latent image indicative of at least the second mask material feature.

In one or more fourteenth embodiments, further to the eleventh through thirteenth embodiments, the mask material layer is first mask material layer, and also including forming a second mask material layer over the first mask pattern.

In one or more fifteenth embodiments, further to the eleventh through fourteenth embodiments, the second mask pattern includes a fourth mask material feature adj acent to the third mask material feature, the fourth mask material feature overlaps no portion of either the first mask material feature or the second mask material feature, and the method further includes removing substantially all of the fourth mask material feature.

In one or more sixteenth embodiments, further to the eleventh through fifteenth embodiments, the second and fourth mask material features are substantially parallel.

In one or more seventeenth embodiments, further to the eleventh through sixteenth embodiments, the second and fourth mask material features are substantially perpendicular.

In one or more eighteenth embodiments, further to the eleventh through seventeenth embodiments, the method also includes increasing a lateral dimension of the first mask material feature or the third mask material feature by depositing a conformal layer over the first or second mask pattern.

In one or more nineteenth embodiments, further to the eleventh through eighteenth embodiments, the first mask material feature includes a first segment, the third mask material feature includes a second segment, the first segment includes the intersected portion and extends in a first longitudinal direction, and the second segment overlaps the intersected portion and extends in a second longitudinal direction substantially perpendicular to the first longitudinal direction.

In one or more twentieth embodiments, further to the eleventh through nineteenth embodiments, the first mask pattern includes a plurality of first segments in the first longitudinal direction, the second mask pattern includes a plurality of second segments in the second longitudinal direction, and the third mask pattern includes an array of substantially rectangular regions located at intersections of the first and second segments.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
an integrated circuit (IC) die;
an array of structures on a layer of the IC die;
a first plurality of substantially parallel first stripes in the layer and adjacent the array, wherein individual ones of the first stripes comprise first indentations in the layer; and
a second plurality of substantially parallel second stripes comprising second indentations in the layer and adjacent the array.

2. The apparatus of claim 1, wherein the first stripes are substantially perpendicular to the second stripes.

3. The apparatus of claim 1, wherein the IC die comprises a plurality of transistor structures at a same level with, or below, the plurality of substantially parallel stripes.

4. The apparatus of claim 1, wherein the IC die comprises a first interconnect structure over the layer and a second interconnect structure under the layer.

5. The apparatus of claim 1, wherein the array comprises the structures arranged in a grid of substantially perpendicular columns and rows.

6. A method comprising:
forming a mask material layer over a target material layer of a substrate;
forming, with a first etch of the mask material layer, a first mask pattern comprising a first mask material feature adjacent to a second mask material feature;
forming a second mask pattern comprising a third mask material feature, wherein the third mask material feature overlaps an intersected portion of the first mask material feature;
forming, with a second etch of the mask material layer, a third mask pattern, the second etch retaining the intersected portion of the first mask material feature and removing substantially all of the second mask material feature; and
etching at least partially through the target material layer based on the third mask pattern.

7. The method of claim 6, further comprising etching entirely through the target material layer and etching into an underlying substrate material layer.

8. The method of claim 7, wherein removing substantially all of the second mask material feature leaves a latent image in the substrate material layer, the latent image indicative of at least the second mask material feature.

9. The method of any one of claims 6-8, wherein the mask material layer is first mask material layer, and further comprising forming a second mask material layer over the first mask pattern.

10. The method of any one of claims 6-9, wherein:
the second mask pattern comprises a fourth mask material feature adjacent to the third mask material feature;
the fourth mask material feature overlaps no portion of either the first mask material feature or the second mask material feature; and
the method further comprises removing substantially all of the fourth mask material feature.

11. The method of claim 10, wherein the second and fourth mask material features are substantially parallel.

12. The method of claim 10, wherein the second and fourth mask material features are substantially perpendicular.

13. The method of any one of claims 6-12, further comprising increasing a lateral dimension of the first mask material feature or the third mask material feature by depositing a conformal layer over the first or second mask pattern.

14. The method of any one of claims 6-13, wherein:
the first mask material feature comprises a first segment;
the third mask material feature comprises a second segment;
the first segment comprises the intersected portion and extends in a first longitudinal direction; and
the second segment overlaps the intersected portion and extends in a second longitudinal direction substantially perpendicular to the first longitudinal direction.

15. The method of claim 14, wherein:
the first mask pattern comprises a plurality of first segments in the first longitudinal direction;
the second mask pattern comprises a plurality of second segments in the second longitudinal direction; and
the third mask pattern comprises an array of substantially rectangular regions located at intersections of the first and second segments.
